Europäisches Patentamt

European Patent Office

Office européen des brevets

(11) Publication number: **0 508 369 A1**

# EUROPEAN PATENT APPLICATION

(21) Application number: **92105984.6**

(22) Date of filing: **07.04.92**

(51) Int. Cl.5: **H03J 1/00**

(30) Priority: **08.04.91 JP 74948/91**

(43) Date of publication of application:
**14.10.92 Bulletin  92/42**

(84) Designated Contracting States:
**DE FR GB**

(71) Applicant: **PIONEER ELECTRONIC CORPORATION**
**No. 4-1, Meguro 1-chome**
**Meguro-ku Tokyo 153(JP)**

(72) Inventor: **Kobayashi, Hideaki, c/o Pioneer Electronic Corp.**
**Kawagoe Kojo, 25-1, Aza Nishimachi, Oaza Yamada**
**Kawagoe-shi, Saitama, 350(JP)**
Inventor: **Hatori, Tomoyasu, c/o Pioneer Electronic Corp.**
**Kawagoe Kojo, 25-1, Aza Nishimachi, Oaza Yamada**
**Kawagoe-shi, Saitama, 350(JP)**
Inventor: **Miyano, Koichi, c/o Pioneer Electronic Corp.**
**Kawagoe Kojo, 25-1, Aza Nishimachi, Oaza Yamada**
**Kawagoe-shi, Saitama, 350(JP)**
Inventor: **Kasa, Kooichi, c/o Pioneer Electronic Corp.**
**Kawagoe Kojo, 25-1, Aza Nishimachi, Oaza Yamada**

**Kawagoe-shi, Saitama, 350(JP)**
Inventor: **Hirano, Sachiyo, c/o Pioneer Electronic Corp.**
**Kawagoe Kojo, 25-1, Aza Nishimachi, Oaza Yamada**
**Kawagoe-shi, Saitama, 350(JP)**
Inventor: **Matsumoto, Isao, c/o Pioneer Electronic Corp.**
**Kawagoe Kojo, 25-1, Aza Nishimachi, Oaza Yamada**
**Kawagoe-shi, Saitama, 350(JP)**
Inventor: **Nagai, Keigo, c/o Pioneer Electronic Corp.**
**Kawagoe Kojo, 25-1, Aza Nishimachi, Oaza Yamada**
**Kawagoe-shi, Saitama, 350(JP)**
Inventor: **Shishido, Osamu, c/o Pioneer Electronic Corp.**
**Kawagoe Kojo, 25-1, Aza Nishimachi, Oaza Yamada**
**Kawagoe-shi, Saitama, 350(JP)**
Inventor: **Nishida, Junichi, c/o Pioneer Electronic Corp.**
**Kawagoe Kojo, 25-1, Aza Nishimachi, Oaza Yamada**
**Kawagoe-shi, Saitama, 350(JP)**

(74) Representative: **Reinhard, Skuhra, Weise**
**Friedrichstrasse 31**
**W-8000 München 40(DE)**

(54) Method for selecting a broadcasting station in a RDS-receiver.

(57) In an RDS receiver being capable of receiving an RDS broadcast wave on which RDS data, such as a plurality of alternative frequency data and programme identification data of the same network group, are frequency-multiplexed, a method for selecting a broadcasting station is used when the receiving condition has deteriorated in the midst of receiving a radio broadcast wave: the RDS receiver automatically starts to tune to an alternative broadcasting station within the same broadcasting network group in order to receive the same programme, preferably a broadcasting station located comparativily close to the receiver is selected. Since, in accordance with this invention, the tuning is performed by reading back the alternative frequency data from the latest in the stored list of alternative frequencies, thus selecting a new network station within a short period of time.

# F I G. 3

## BACKGROUND OF THE INVENTION

Field of the Invention

This invention relates to a method of selecting a broadcasting station for a radio receiver and, more particularly, to a method of receiving a radio data system (RDS) signal multiplexed on a broadcast wave with use of an RDS radio receiver.

Description of the Prior Art

A new FM broadcasting system has been proposed by European Broadcasting Union (EBU), wherein programme type data, traffic programme identification data, enhanced other network data such as of alternative frequencies, all of which bear the same programme as that of presently receiving, and the like are broadcasted as an RDS signal by frequency-multiplexing onto an FM stereophonic signal.

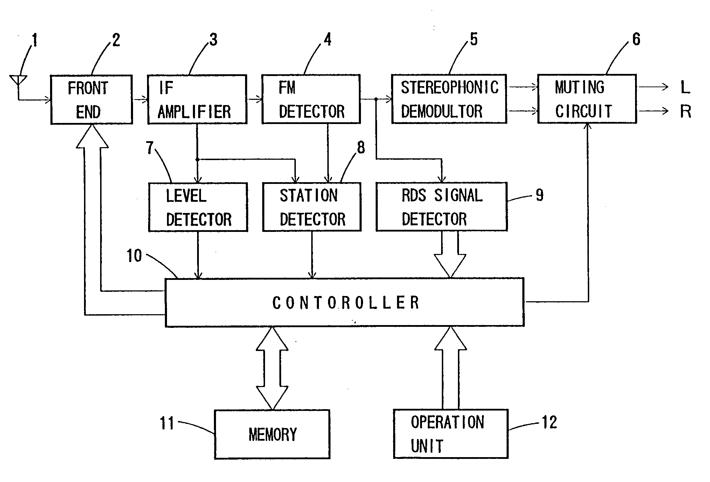

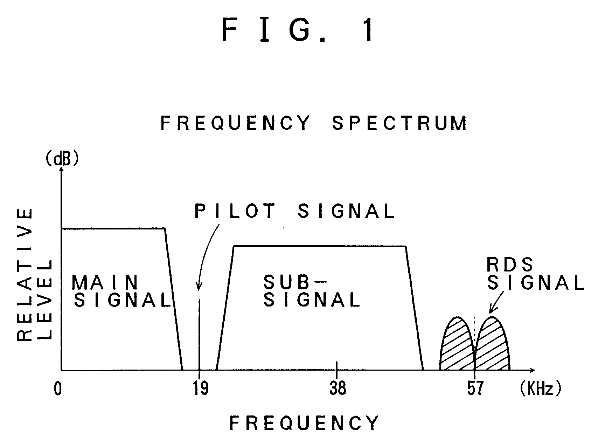

The RDS signal is a two-phase DPSK signal having a bit rate of 1187.5 bps, a frequency spectrum of which is shown in Fig. 1, and is frequency-multiplexed on an auxiliary carrier wave of 57 KHz, which is the third harmonic wave of a 19 KHz pilot signal for stereophonic sounds and located at the outside of a frequency bandwidth of an FM wave, by way of an amplitude modulation in accordance with a carrier suppression system.

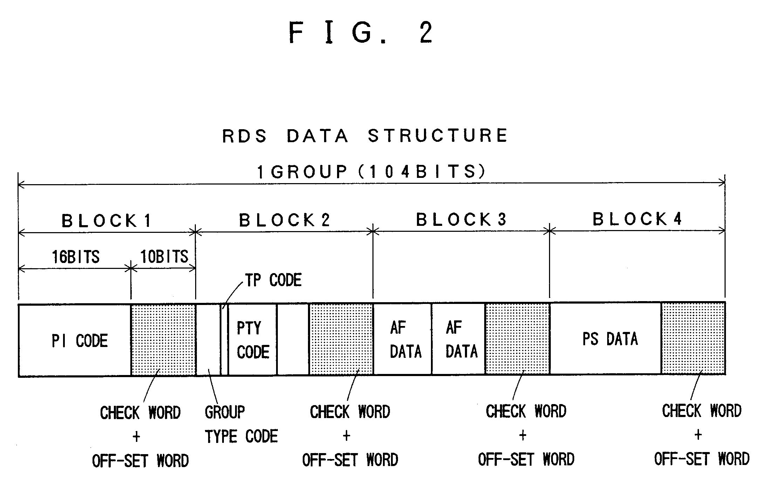

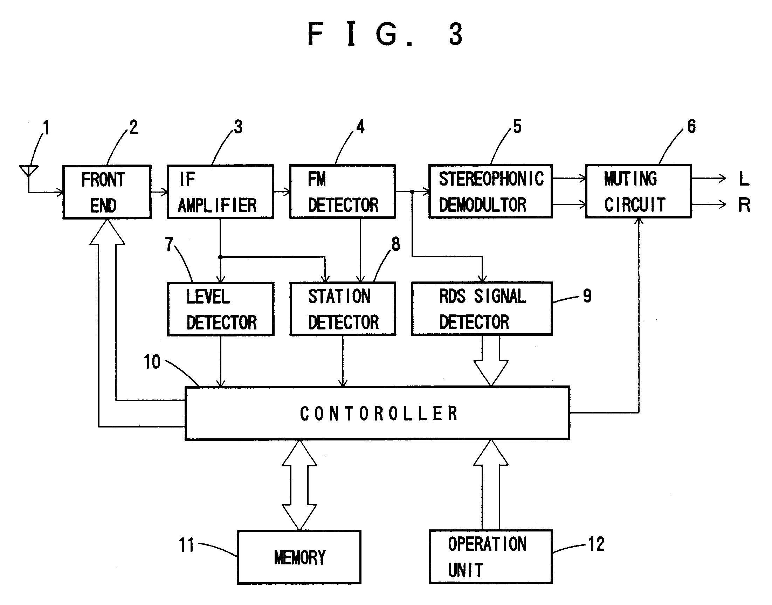

A data structure of a base band of the RDS signal is shown in Fig. 2, wherein the data has 104 bits to form one group and is divided into four blocks, each block includes twenty six bits whereby sixteen bits of which are assigned for an information word and that ten bits for a check word. Contents of each information word are defined by group type codes which will be explained hereinafter. The check word provide a parity bit of each block with an off-set assigned for every block.

As to the information word of each block, the information word of the block 1 always designates a 16-bit programme identification (PI) code containing information to identify a country, area, network and the like. The information word of the block 2 contains a 4-bit group type code, 1-bit traffic programme identification (TP) code, 5-bit programme type (PTY) code and the like.

The information words of the blocks 3 and 4 are prescribed in response to the group type defined by the group type code of the block 2. As to an information in accordance with the present invention, there are 8-bit alternative frequency (AF) data in the block 3 for designating the frequency data of neighboring network stations which broadcast the same programme as that of the broadcasting station presently in listening, and that 16-bit program service name (PS) data in the block 4 for designating the name data relating to names of broadcasting stations for use in displaying a station name of the listening broadcasting station.

One of the utilities of the RDS signal is a network follow-up function. In accordance with this function, during the movement such as by a motor vehicle, for example, the PI code and AF data multiplexed on the receiving radio broadcast wave are decoded and resultants are stored as an AF list, in the order decoded, in a prescribed area of a memory. The stored AF data are read out in the order stored at the time when the receiving condition is changed for the worse in the midst of receiving a radio broadcast wave from a selected broadcasting station and then the RDS receiver automatically starts to tune in another broadcasting station within the same broadcasting network group in order to receive the same programme in a good receiving condition at all times.

To tune in another broadcasting station with good reception within the same broadcasting network group by reading back the AF data from the AF list in accordance with a prior-art method, the tuning is performed in such an order that the AF data have been stored in the AF list.

However, if the order of storing the AF data is the same as that of read back like in the prior-art method, there is a possibility of tuning such as to start with a network station located at the most distant point from the present position when traveling a long distance, thus resulting in a problem of taking a long period of time before switching over to another broadcasting station which is in good receiving condition.

It is therefore an object of this invention to provide a method of shortening a time required for an RDS receiver in selecting a broadcasting station at the time when a receiving condition is changed for the worse and the RDS receiver automatically starts to tune in another broadcasting station within a group of broadcasting networks which is broadcasting the same programme as that of listening.

## SUMMARY OF THE INVENTION

In an RDS receiver being capable of receiving an RDS broadcast wave on which RDS data, such as a plurality of alternative frequency data and programme identification data concerning about the same network group, are frequency-multiplexed, the present invention comprises the steps of: a first processing step for storing, in the order decoded, the alternative frequency data in a prescribed area of a memory to provide a list of alternative frequencies for each network; a second processing step for storing the programme identification code, upon receiving a command, by decoding a received radio wave broadcasted from a listening broadcasting station; and a third processing step for selecting an alternative broadcasting station, by reading back the alternative frequency data, in the order from newly stored, of the same broadcasting network group as that of the listening broadcasting station from the list of alternative frequencies provided by the first processing step, upon detecting a presence of such alternative broadcasting station, which corresponds to the read-out alternative frequency data, when whose programme identification data is discriminated identical to the programme identification code stored at the second processing step and whose broadcast wave has a signal level at or above a predetermined signal level.

Consequently, in accordance with the method of selecting a broadcasting station embodying the present invention, at the time when the receiving condition has changed for the worse in the midst of receiving a broadcast wave from the listening broadcasting station and then the RDS receiver automatically starts to tune in an alternative broadcasting station within the same broadcasting network group by reading back the alternative frequency data of the same network group from the stored list of alternative frequencies in order to receive the same programme as that of listening, it is possible to select a new network station located in comparative close to the listening broadcasting station, then in order, since the tuning is performed by reading back the frequency data from the latest in the stored list of alternative frequencies, thus selecting the new network station, as an alternative, in good reception within a short period of time.

**BRIEF DESCRIPTION OF THE DRAWINGS**

Fig. 1 is a frequency spectrum diagram showing a stereophonic signal including an RDS signal;

Fig. 2 is a diagram showing an RDS data structure of a base band;

Fig. 3 is a block diagram showing a fundamental structure of an RDS receiver for use in implementing a method of selecting a radio broadcasting station embodying the present invention;

Fig. 4 is a block diagram showing an RDS signal detecting stage of Fig. 3;

Fig. 5 is a flow chart showing operational steps for providing an AF list in accordance with the present invention;

Fig. 6 is a diagram showing an example of the AF list provided by implementing the operational steps of Fig. 5; and

Fig. 7 is a flow chart showing operational steps for implementing a network follow-up process in accordance with the present invention.

**DETAILED DESCRIPTION OF THE PREFERRED EMBODIMENT**

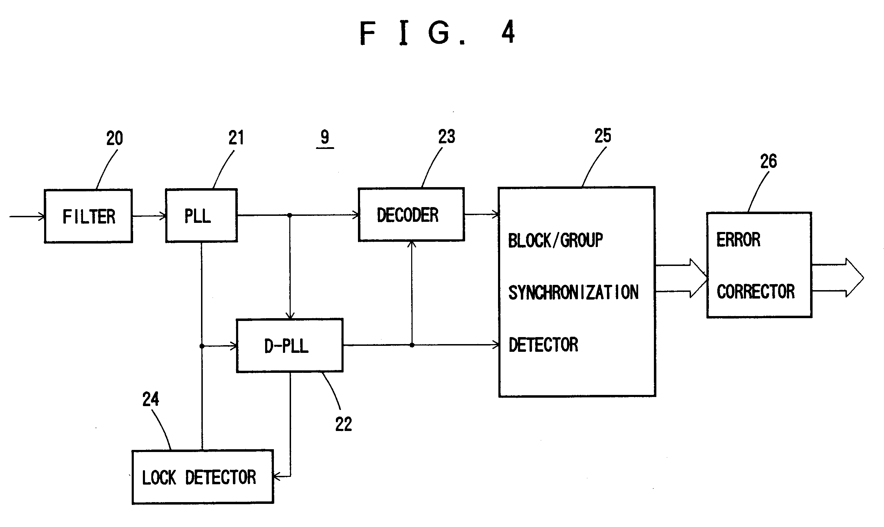

A preferred embodiment of this invention will now be described in detail by referring to the accompanying drawings. Referring first to Fig. 3, there is shown a block diagram of a fundamental structure of an RDS receiver to implement a method of selecting a broadcasting station in accordance with the present invention.

In Fig. 3, an FM broadcast wave multiplexed with an RDS signal, which is received by an antenna 1, is converted into an intermediate frequency (IF) of 10.7 MHz at a front end 2 after a desired broadcast wave being selected and is amplified with use of an IF amplifier 3. The front end 2 consists of, for example, a Phase-Locked Loop (PLL) synthesizer including a programmable divider, whereby a dividing ratio of the programmable divider is controlled to perform a tuning operation.

The FM signal of 10.7 MHz amplified and limited at the IF amplifier 3 is restored to an audio signal at an FM detector 4 and, when the broadcast is a stereophonic broadcast, the limited FM signal is separated into audio signals of left (L) and right (R) at a stereophonic demodulator 5 for outputting reproduced L and R audio signals through a muting circuit 6.

There are also provided a level detector 7 to detect a received signal level (electric field strength) based on an IF signal level at the IF amplifier 3, and a station detector 8 to output a station detection signal to provide the detection of a broadcasting station when the received signal is at or above a predetermined signal level and that an output detected on an S-curve characteristic at the FM detector 4 is within a range of predetermined levels.

Further, there is provided an RDS signal detector 9 to detect an RDS signal from the detected output of the FM detector 4, whereby RDS signal detected by the RDS signal detector, the received signal level detected by the level detector 7 and the station detecting signal detected by the station detector 8 are all fed to a controller 10 comprising a microcomputer.

The controller 10 accepts an information word of each block contained in the RDS signal being fed as a group unit, or accepts such as PI code, AF data, PS data and the like and stores them in a memory 11. A desired broadcasting station, or a broadcasting station other than the broadcasting station presently in contact within the same network, is selected by controlling the division ratio of the programmable divider, which constitutes a part of the front end, based on a tune-in command given through an operation unit 12 or AF data read out from the AF list during the network follow-up process. In addition to this, the controller 10 outputs a switching signal to turn off a muting circuit 6 in a duration of tuning operation.

Fig. 4 is a block diagram showing a detailed circuit arrangement of the RDS signal detector 9 of Fig. 3. This detector is a circuit provided for extracting the RDS signal from a stereophonic composite signal output from the FM detector 4 and outputs the RDS data wherein one group consists of 104 bits.

The operation of the RDS signal detector 9 will be described hereinafter. The detected output of the FM detector 4 is fed to a filter circuit 20 and thereby extracted is a 57 KHz subcarrier wave. A PLL circuit 21 demodulates the RDS signal multiplexed on the subcarrier wave through amplitude modulation. A D-PLL circuit 22 generates a clock signal for use in data decoding from the RDS signal. A lock detector circuit 24 detects a state of D-PLL circuit 22 whether it is in a state of locking or unlocking and switches over lock ranges of the PLL circuit 21 and D-PLL circuit 22 based on the detected output thereof.

The RDS signal demodulated at the PLL circuit 21 is then decoded at the decoder 23 in synchronous with the clock signal fed from the D-PLL circuit 22, and converted into the RDS data wherein one group includes 104 bits made up of 4 blocks each of which has 26 bits, as shown in Fig. 2. The RDS data are then fed sequentially to a block/group synchronization detector 25 at every group for providing a synchronization between the groups and blocks based on offset words allotted to 10-bit check words of each block, and error detection for 16-bit information words is implemented simultaneously based on the check words. The error-detected data are then error corrected at an error correcting circuit 26 and fed to the controller 10.

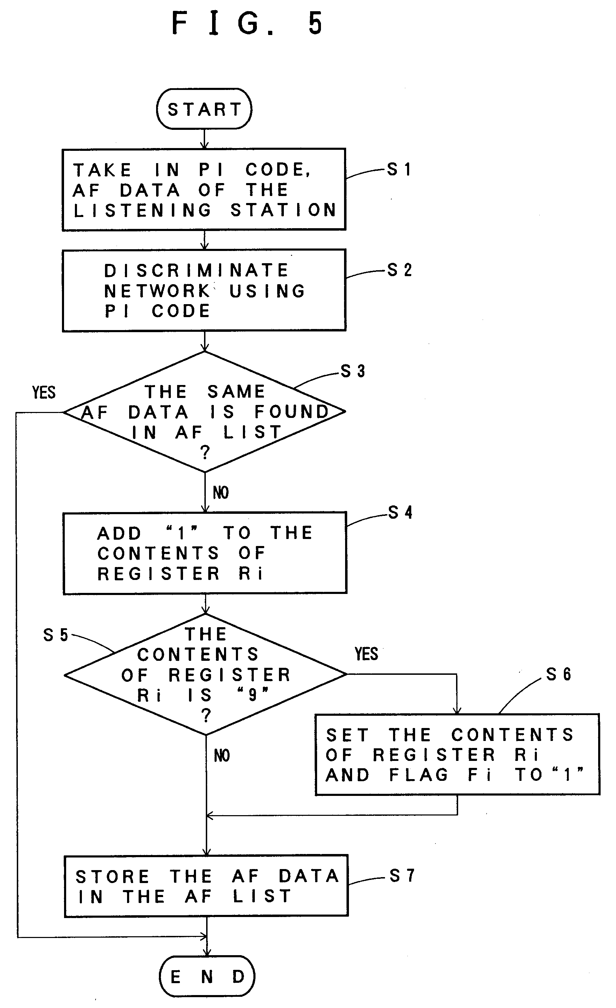

A process for providing an AF list, by taking in the PI code and AF data contained in the RDS data being multiplexed on the broadcast wave in reception, will be described hereinafter by referring to a flowchart of Fig. 5.

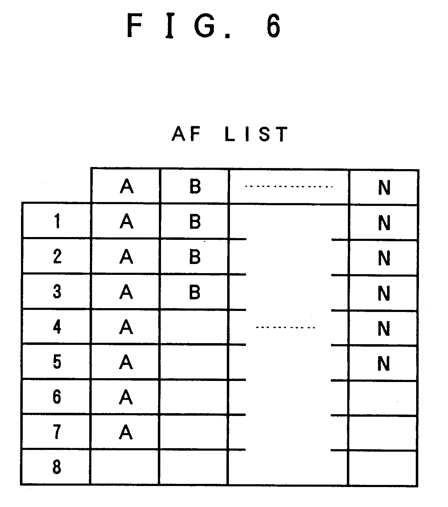

This process is performed when a new broadcasting station is tuned in upon receiving the tune-in command from the operation unit 12 or in a duration of executing the network follow-up process, whereas, for example, the AF list has already stored in the memory 11, as shown in Fig. 6. The AF list of this type is capable of storing the maximum of eight kinds of AF data, from a list one to list eight in order, in a plurality of networks A - N. In the example shown in Fig. 6, seven kinds of AF data $A_1$ - $A_7$ are stored in the network A, three kinds of AF data $B_1$ - $B_3$ are stored in the network B, ..... and five kinds of AF data $N_1$ - $N_5$ are stored in the network N.

The controller 10 receives the PI code and AF data, after demodulation, from the RDS signal multiplexed on the FM broadcast wave presently in reception, and stores them in a predetermined area in the memory 11 (Step S1). Step S2 discriminates a broadcasting network from the stored PI code, and it is searched at step S3 whether or not the same AF data has already been stored in the AF list of the discriminated network. If it has, the process for providing the AF list will be terminated, whereas if it has not, "1" is accumulated at step S4 to the contents of a resistor Ri (i = A, B, ..., N) provided for each network. At step S5, it is checked whether or not an accumulated number reaches to "9". If it is, the contents of the register Ri is set to "1" and, at the same time, a flag Fi is set to "1" at step S6 to designate that the AF list of the corresponding network is filled up.

In each register Ri, stored is a number of AF data which is stored in the AF list of each network. In the AF list shown in Fig. 6, for example, number "7" is stored in the register $R_A$ that corresponds to the network A, number "3" is stored in the register $R_B$ that corresponds to the network B, ...., and number "5" is stored in the register $R_N$ that corresponds to the network N. Accordingly, if the AF data of the network B is taken in at the step S1, for example, the contents of the register $R_B$ will be changed to "4" by implementing the process of step S4. Further, if the eight kinds of AF data have already been stored in a certain network, the contents of the register Ri is set to "1" and simultaneously the flag Fi, which indicates the saturation of the AF list, is set to "1" in order to store new AF data by rewriting the contents of the list one.

If it is checked at step S5 that the accumulated number is not reached to "9", step S7 stores the AF data in a selected storage area of the register Ri assigned for the network of the AF list to terminate the AF list providing process. More specifically, in the example shown above, the AF data taken in a position of list 4 of the network B is stored as AF data $B_4$, in like way, AF data are stored in order from the list one of the AF list in separate networks.

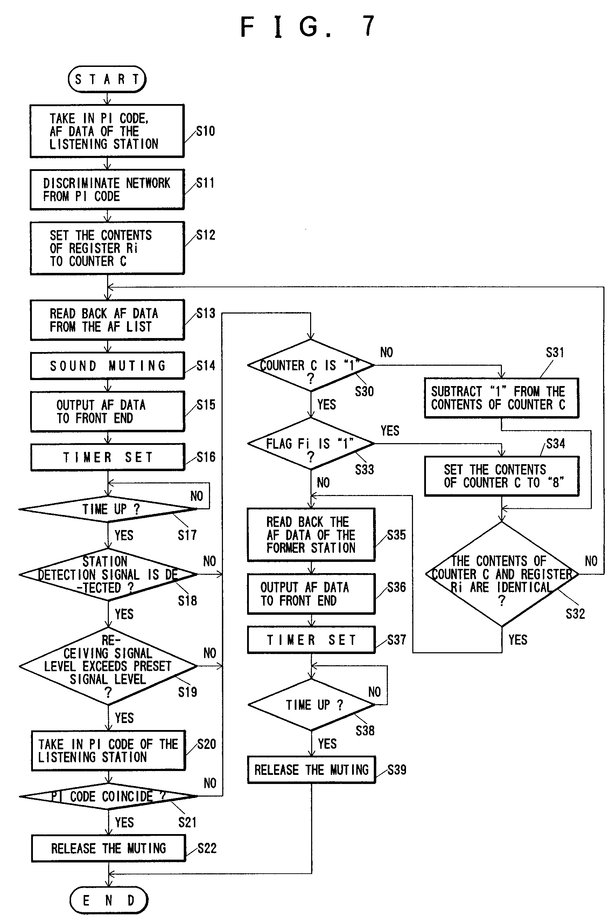

The operation of the network follow-up process to be implemented in response to a switching command, which is generated at the time when the reception sensitivity of the FM broadcast presently in reception is decreased, will be described hereinafter by referring to a flowchart shown in Fig. 7.

Upon initiation of the process, the PI code and AF data are decoded at step S10 from the RDS signal contained in the broadcast wave presently in reception and stored in a prescribed area of the memory 11. Step S11 discriminates a broadcasting network from the stored PI code and, then, step S12 sets the contents of the register Ri which corresponds to the discriminated broadcasting network to a counter C. The contents of the register Ri designate a memory location where stored are the latest AF data among the AF data stored in the AF list as it is apparent from the AF list providing process shown in the flowchart of Fig. 5. Accordingly, the memory location of the latest AF data is set to the counter C.

Following to step S12, step S13 reads the AF data in the memory location addressed in view of the contents of the counter, or the latest AF data, from the stored AF list. Step S14 in turn provides the muting circuit 6 with a muting. Step S15 outputs the read out AF data to the programmable divider of the PLL synthesizer at the front end 2 and, at the same time, step S16 sets a timer so as to provide a time required for locking the PLL synthesizer.

Upon elapsing the set time of the timer (step S17), it is discriminated at step S18 whether or not there is any broadcasting station to tune in based on a station detection signal fed from the station detector 8. If there is not, the programme goes to step S30, the operation of which will be explained in detail hereinafter, for checking the contents of the counter, whereas if there is, it is determined at step S19 whether or not a received signal level fed from the level detector 7 exceeds a predetermined value. If the received signal level exceeds the predetermined value, step S20 takes in the PI code from the RDS signal contained in the newly received broadcast wave, and at step 21, it is determined whether or not this PI code is identical to that of the former broadcasting station in reception which has previously been taken in at step S10. If it is not, the programme goes to step S30, whereas if it is, step S22 releases the audio muting of the muting circuit 6. In this way, selected is a broadcasting station which belongs to the same broadcasting network group and is broadcasting the same programme as that has been listening, and the network follow-up process is brought to end.

If it is discriminated at step S18 that there is no broadcasting station to receive based on a station detection signal fed from the station detector 8 and that, if the receiving signal is less than the predetermined set value in strength, further if it is determined at step S21 that the PI codes are not the same, it is determined at step S30 whether or not the contents of the counter C is "1". If it is not, a decrement is given to the counter C at step S31, and it is checked at step S32 whether or not the decreased count value of the counter C coincides with the contents of the register Ri. If it is not, the programme returns to step S13 for repeating the operational steps as described above.

If it is determined at step S30 that a count value of the counter C is "1", it is decided at step S33 whether or not the flag Fi is "1", in other words, the AF list of the corresponding network is full of AF data. If it is, step S34 sets the count value of the counter C to the maximum value of "8". It is then determined at step S32 whether or not the count value of the counter C coincides with the contents of the register Ri. If it is not, the programme returns to step S13 for repeating the operational steps as described above.

If it is determined at step S32 that the count value of the counter C is identical to the contents of the register Ri, or if it is decided at step S33 that the flag Fi is "0", the retrieval for the AF list of the corresponding network is brought to end as there is no receivable network broadcasting station, and putting the RDS receiver back to tune in the former broadcasting station in accordance with operational steps of step S35 and the followings hereinafter described in detail.

In accordance with the operational steps as described above, for example, if it is assumed that the AF data are stored in the AF lists one through five of the corresponding broadcasting networks, the read out of the AF data will be commenced from the latest AF data stored in the AF list five. If a receivable station is not found in the AF list five, the read out of the AF data is continued to a subordinate order such as the AF list four, AF list three, ..., AF list one by giving a decrement to the counter C until the acquisition of receivable network station. The retrieval of the AF list will be terminated when the count value of the counter C reaches to "1".

Further, if it is assumed that the AF data are stored in the whole AF lists, one through eight, of the corresponding broadcasting networks and the latest AF data is stored in the AF list six, the read out of the AF data will be commenced from the latest AF data stored in the AF list six. If a receivable station is not found in the AF list six, the read out of the AF data is continued to a subordinate order such as the AF list five, AF list four, ..., AF list one by giving a decrement to the counter C until the acquisition of receivable network station. The contents of the counter C is set to "8" when the count value reaches to "1" in the process of the retrieval, and the read out of the AF data is again continued to the subordinate order from the AF list eight then to the AF list seven and the retrieval of the AF list will be terminated when count value of the counter C reaches to "6".

Now back to the flowchart of Fig. 7, operational steps following the step S35 will be described hereinafter. If it is decided at step S32 that the count value of the counter C and the contents of the register Ri are identical to each other, or if it is decided at the step S32 that the flag Fi is "0", step S35 reads the frequency data of the former broadcasting station stored at step S10. At step S36, the read out frequency data are fed to the programmable divider of the front end 2 and, simultaneously, step S37 sets the timer. Upon elapsing the set time of the timer (step S38), step S39 releases the audio muting of the muting circuit 6, whereby the broadcast wave reception by the RDS receiver is returned to the former broadcasting station.

In accordance with the present invention, since the AF data stored in the AF list are read out from the latest AF data to the old in order during the operation of network follow-up process, the selection of broadcasting station to tune in next can be started from a broadcasting station which is located comparatively close to the point where the RDS receiver is presently positioned. Accordingly, in accordance with the present invention, it is possible to select a network station of good reception within a short period of time, thus decreasing a time required for tuning to a great extent.

It is to be understood by those skilled in the art that the foregoing description relates only to a preferred embodiment of the invention and that various changes and modifications may be made in the invention without departing from the spirit and scope thereof.

In an RDS receiver being capable of receiving an RDS broadcast wave on which RDS data, such as a plurality of alternative frequency data and programme identification data of the same network group, are frequency-multiplexed, a method of selecting a broadcasting station in which, at the time when the receiving condition has changed for the worse in the midst of receiving a radio broadcast wave and then the RDS receiver automatically starts to tune in an alternative broadcasting station within the same broadcasting network group in order to receive the same programme as that of listening, a new network station located in comparative close to the listening broadcasting station is selected at first then in order. Since, in accordance with this invention, the tuning is performed by reading back the alternative frequency data from the latest in the stored list of alternative frequencies, thus selecting the new network station, as an alternative, in good reception within a short period of time.

**Claims**

1.  A method of selecting a broadcasting station for an RDS receiver being capable of receiving an RDS broadcast wave of the type, wherein a plurality of alternative frequency data and programme identification data concerning about the same broadcasting network group are frequency-multiplexed on a broadcast wave, comprising the steps of:

a first processing step for storing said plurality of alternative frequency data in a prescribed area of a memory, in the order decoded, to provide a list of alternative frequencies for each network;

a second processing step for storing said programme identification data, upon receiving a command, by decoding a received broadcast wave from a listening broadcasting station; and

a third processing step for selecting an alternative broadcasting station, by reading back the alternative frequency data, in the order from newly stored, of the same broadcasting network group as that of the listening broadcasting station from the list of alternative frequencies provided by the first processing step, upon detecting a presence of such alternative broadcasting station, which corresponds to the read-out alternative frequency data, when whose programme identification data is discriminated identical to the programme identification code stored at the second processing step and whose broadcast wave has a signal level at or above a predetermined signal level.

2.  A method of selecting a broadcasting station for an RDS receiver as defined in claim 1, wherein a network follow-up process is initiated automatically when a receiving condition is changed to the worse.

3.  A method of selecting a broadcasting station for an RDS receiver as defined in claim 1, wherein a network follow-up process is initiated based on a tune-in command given through an operation unit.

4.  A method of selecting a broadcasting station for an RDS receiver as defined in claim 1, wherein an alternative broadcasting station is selected by controlling a division ratio of a programmable divider, which constitutes a part of a front end, based on the alternative frequency data read out from the list of alternative frequencies.

FRONT END 2

IF AMPLIFIER 3

FM DETECTOR 4

STEREOPHONIC DEMODULTOR 5

MUTING CIRCUIT 6

L
R

LEVEL DETECTOR 7

STATION DETECTOR 8

RDS SIGNAL DETECTOR 9

CONTOROLLER 10

MEMORY 11

OPERATION UNIT 12

1

# F I G. 1

FREQUENCY SPECTRUM

# F I G.  2

## RDS  DATA  STRUCTURE

### 1GROUP (104BITS)

| BLOCK 1 | BLOCK 2 | BLOCK 3 | BLOCK 4 |

16BITS · 10BITS

TP CODE

| PI CODE | | PTY CODE | | AF DATA | AF DATA | | PS DATA | |

CHECK WORD + OFF-SET WORD　　GROUP TYPE CODE　　CHECK WORD + OFF-SET WORD　　CHECK WORD + OFF-SET WORD　　CHECK WORD + OFF-SET WORD

EP 0 508 369 A1

# F I G. 3

EP 0 508 369 A1

# F I G. 4

FILTER 20 → PLL 21 → 9 → DECODER 23 → BLOCK/GROUP SYNCHRONIZATION DETECTOR 25 → ERROR CORRECTOR 26

D-PLL 22

LOCK DETECTOR 24

EP 0 508 369 A1

EP 0 508 369 A1

# FIG. 5

```
                    ( START )
                        |
        ┌───────────────────────────────┐
        │  TAKE IN PI CODE,             │── S1
        │  AF DATA OF THE               │
        │  LISTENING STATION            │
        └───────────────────────────────┘
                        |
        ┌───────────────────────────────┐
        │  DISCRIMINATE                 │── S2
        │  NETWORK USING                │
        │  PI CODE                      │
        └───────────────────────────────┘
                        |
                   ╱ ─────── ╲           S3
         YES      ╱  THE SAME  ╲
    ┌───────────<  AF DATA IS FOUND >
    │            ╲   IN AF LIST  ╱
    │             ╲     ?     ╱
    │                ╲─────╱
    │                   | NO
    │        ┌───────────────────────────────┐
    │        │  ADD  "1"  TO THE             │── S4
    │        │  CONTENTS OF                  │
    │        │  REGISTER Ri                  │
    │        └───────────────────────────────┘
    │                   |
    │              ╱ ─────── ╲
    │    S5       ╱   THE      ╲
    │            ╱  CONTENTS     ╲   YES
    │          <  OF REGISTER      >───────────┐
    │            ╲  Ri IS  "9"   ╱             |
    │             ╲     ?      ╱               |
    │                ╲──────╱           ┌───────────────────────────────┐
    │                   | NO            │  SET THE CONTENTS             │── S6
    │                   |               │  OF REGISTER Ri               │
    │                   |               │  AND FLAG Fi  TO "1"          │
    │                   |               └───────────────────────────────┘
    │                   |                       |
    │                   |←──────────────────────┘
    │        ┌───────────────────────────────┐
    │        │  STORE THE AF DATA            │── S7
    │        │  IN THE AF LIST               │
    │        └───────────────────────────────┘
    │                   |
    └───────────────────┤
                        |
                   ( END )
```

13

# F I G. 6

AF LIST

|   | A | B | ················ | N |
|---|---|---|---|---|
| 1 | A | B |   | N |
| 2 | A | B |   | N |
| 3 | A | B |   | N |
| 4 | A |   | ············ | N |
| 5 | A |   |   | N |
| 6 | A |   |   |   |
| 7 | A |   |   |   |
| 8 |   |   |   |   |

FIG. 7

```
                    ┌──────────┐
                    │ S T A R T │
                    └─────┬────┘
                          │
          ┌───────────────────────┐
          │ TAKE IN PI CODE,       │ S10
          │ AF DATA OF THE         │
          │ LISTENING STATION      │
          └───────────┬───────────┘
                      │
          ┌───────────────────────┐
          │ DISCRIMINATE NETWORK   │ S11
          │ FROM PI CODE           │
          └───────────┬───────────┘
                      │
          ┌───────────────────────┐
          │ SET THE CONTENTS       │ S12
          │ OF REGISTER Ri         │
          │ TO COUNTER C           │
          └───────────┬───────────┘
                      │
          ┌───────────────────────┐
          │ READ BACK AF DATA      │ S13
          │ FROM THE AF LIST       │
          └───────────┬───────────┘
                      │
          ┌───────────────────────┐
          │ SOUND  MUTING          │ S14
          └───────────┬───────────┘
                      │
          ┌───────────────────────┐
          │ OUTPUT AF DATA         │ S15
          │ TO FRONT END           │
          └───────────┬───────────┘
                      │
          ┌───────────────────────┐
          │ TIMER  SET             │ S16
          └───────────┬───────────┘
```

S10 TAKE IN PI CODE, AF DATA OF THE LISTENING STATION

S11 DISCRIMINATE NETWORK FROM PI CODE

S12 SET THE CONTENTS OF REGISTER Ri TO COUNTER C

S13 READ BACK AF DATA FROM THE AF LIST

S14 SOUND  MUTING

S15 OUTPUT AF DATA TO FRONT END

S16 TIMER  SET

S17 TIME UP ? — NO / YES

S18 STATION DETECTION SIGNAL IS DE-TECTED ? — NO / YES

S19 RE-CEIVING SIGNAL LEVEL EXCEEDS PRESET SIGNAL LEVEL ? — NO / YES

S20 TAKE IN PI CODE OF THE LISTENING STATION

S21 PI CODE COINCIDE ? — NO / YES

S22 RELEASE THE MUTING

E N D

S30 COUNTER C IS "1" ? — NO / YES

S31 SUBTRACT "1" FROM THE CONTENTS OF COUNTER C

S33 FLAG Fi IS "1" ? — YES / NO

S34 SET THE CONTENTS OF COUNTER C TO "8"

S32 THE CONTENTS OF COUNTER C AND REGISTER Ri ARE IDENTICAL ? — NO / YES

S35 READ BACK THE AF DATA OF THE FORMER STATION

S36 OUTPUT AF DATA TO FRONT END

S37 TIMER  SET

S38 TIME UP ? — NO / YES

S39 RELEASE THE MUTING

15

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 326 746 (PIONEER ELECTRONIC CORPORATION) <br> * the whole document * <br><br> ----- | 1-4 | H03J1/00 |
|  |  |  | **TECHNICAL FIELDS SEARCHED (Int. Cl.5 )** <br><br> H03J <br> H04H |

The present search report has been drawn up for all claims

| Place of search | Date of completion of the search | Examiner |
|---|---|---|
| THE HAGUE | 27 MAY 1992 | PEETERS M.M.G. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
......................................................................................
& : member of the same patent family, corresponding
   document

EPO FORM 1503 03.82 (P0401)